Europäisches Patentamt

European Patent Office

Office européen des brevets

(11) Veröffentlichungsnummer: **0 302 170**
**A1**

(12) EUROPÄISCHE PATENTANMELDUNG

(21) Anmeldenummer: 88104144.6

(51) Int. Cl.⁴: **G01R 21/00**

(22) Anmeldetag: 16.03.88

(30) Priorität: 06.08.87 CH 3030/87

(43) Veröffentlichungstag der Anmeldung:
08.02.89 Patentblatt 89/06

(84) Benannte Vertragsstaaten:
AT BE CH DE ES FR GB GR IT LI NL SE

(71) Anmelder: LGZ LANDIS & GYR ZUG AG

CH-6301 Zug(CH)

(72) Erfinder: Joder, Anreas
Binzenmatt 7
CH-6314 Unterägeri(CH)
Erfinder: Renggli, Franz
Fluhmattstrasse 8A
CH-6033 Buchrain(CH)

(54) Anordnung zur Ermittlung einer Leistungssumme und zur Verwendung insbesondere in Mehrphasen-Elektrizitätszählern.

(57) Die Anordnung enthält mindestens zwei Eingangsschaltungen (1a, 1b, 1c), die je eine Kaskadenschaltung eines Eingangswandlers (2a, 2b, 2c) und eines nachgeschalteten Multiplizierers (3a, 3b, 3c) enthalten Jedem Multiplizierer (3a, 3b, 3c) ist ein Spannungs/Frequenz-Wandler (4a, 4b, 4c) in Kaskade nachgeschaltet. Die Eingangsschaltungen (1a, 1b, 1c) sind in einer Reihenfolge hintereinander angeordnet. Jedem Spannungs/Frequenz-Wandler (4a, 4b, 4c) ist ein Addierer (5a, 5b, 5c) in Kaskade nachgeschaltet mit Hilfe erster Eingänge (E11, E12) des Addierers (5a, 5b, 5c), dessen Ausgang seinerseits den Ausgang der Eingangsschaltung (1a, 1b, 1c) bildet und dessen zweite Eingänge (E21, E22) jeweils mit den Ausgängen der vorhergehenden Eingangsschaltung (1a bzw. 1b) verbunden sind. Beide Ausgänge einer Eingangsschaltung (1a, 1b) sind fakultativ jeweils über eine Kaskadenschaltung eines Ternärcodierers (6a, 6b) und eines nachgeschalteten Ternärdecodierers (7a, 7b) mit den zweiten Eingängen (E21, E22) der Addierer (5a, 5b, 5c) der nachfolgenden Eingangsschaltung (1b, 1c) verbunden. Die beiden Ausgänge des Addierers (5c) der letzten Eingangsschaltung (1c) sind mit den Eingängen eines Vorwärts/Rückwärts-Zählers (8) und fakultativ mit den Eingängen eines weiteren Ternärdecodierers (6c) verbunden. Jeder der beiden Ausgänge des Vorwärts/Rückwärts-Zählers (8) ist über einen Motortreiber (9a bzw. 9b) mit einem Schrittmotor (10a bzw. 10b) und/oder über einen Diodentrei- ber (11a bzw. 11b) mit einer Leuchtdiode (12a bzw. 12b) verbunden. Die Schrittmotoren (10a, 10b) betä- tigen je eine Anzeige (13a bzw. 13b).

Fig.1

## Anordnung zur Ermittlung einer Leistungssumme und zur Verwendung insbesondere in Mehrphasen-Elektrizitätszählern

Die Erfindung bezieht sich auf eine Anordnung zur Ermittlung einer Leistungssumme und zur Verwendung insbesondere in Mehrphasen-Elektrizitätszählern gemäss dem Oberbegriff des Anspruchs 1.

Derartige Anordnungen werden mit Vorteil in Mehrphasenzählern verwendet zur Messung der Summe elektrischer Leistung aller Phasen oder in Summenzählern zur Messung der Summe beliebiger Leistungen. Die genannten Leistungen können dabei Wirk-, Blind- oder Scheinleistungen sein. In Elektrizitätszählern wird diese Summe anschliessend über eine Zeit integriert, um den zugehörigen Energiewert zu ermitteln, der anschliessend angezeigt wird.

Eine Anordnung der eingangs genannten Art ist aus der DE 31 15 522 A1 bekannt.

Der Erfindung liegt die Aufgabe zugrunde, eine Anordnung der eingangs genannten Art zu schaffen, die einen einfachen Aufbau besitzt und es gestattet Einstromsysteme, insbesondere Einphasensysteme, zu verwenden und auf einfache Art zusammenzuschalten zwecks Ermittlung der Leistungssumme.

Die genannte Aufgabe wird erfindungsgemäss durch die im Kennzeichen des Anspruchs 1 angegebenen Merkmale gelöst.

Ein Ausführungsbeispiel der Erfindung ist in der Zeichnung dargestellt und wird im folgenden näher beschrieben.

Es zeigen:

Fig. 1 ein vereinfachtes Blockschaltbild einer erfindungsgemässen Anordnung zur Ermittlung einer Summe von drei Leistungen bzw. von drei Energien,

Fig. 2 ein Blockschaltbild eines Addierers positiver und negativer Leistungen,

Fig. 3 ein Blockschaltbild einer Synchronisierungsanordnung,

Fig. 4 ein Blockschaltbild eines Ternärcodierers,

Fig. 5 ein Blockschaltbild eines Ternärdecodierers und

Fig. 6 ein Blockschaltbild eines Impulsformers.

Gleiche Bezugszahlen bezeichnen in allen Figuren der Zeichnung gleiche Teile.

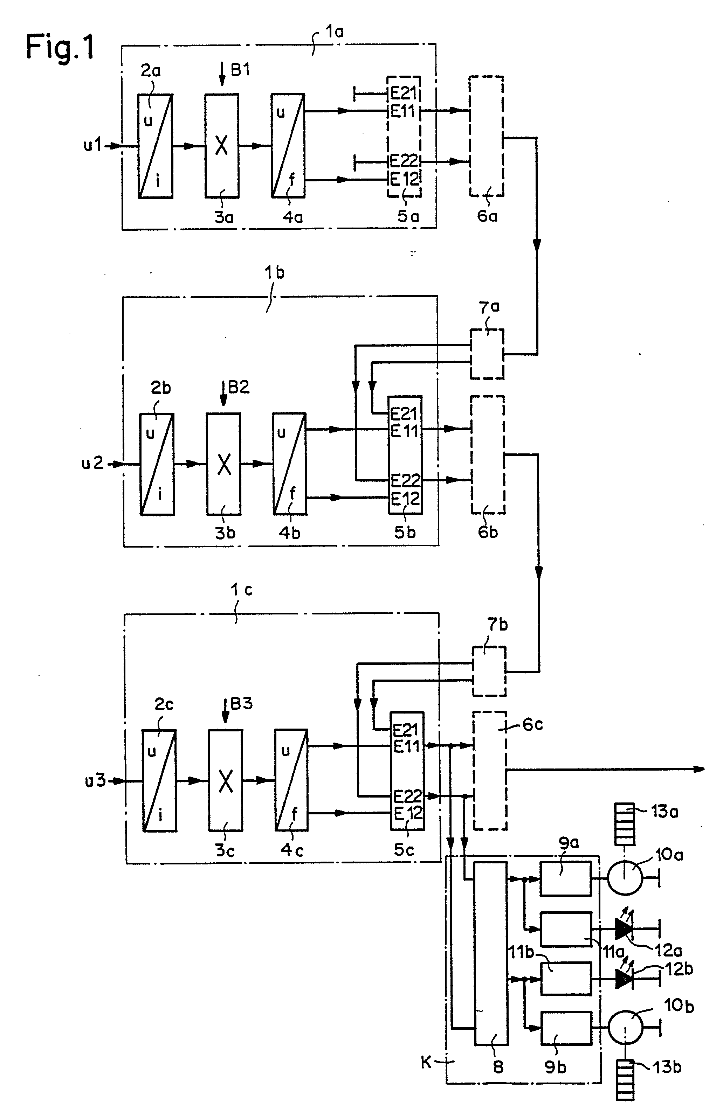

Die erfindungsgemässe Anordnung besitzt mindestens zwei Eingangsschaltungen. In der in der Fig. 1 dargestellten Anordnung wurde angenommen, dass drei Eingangsschaltungen 1a, 1b und 1c vorhanden sind. Die Eingangsschaltungen sind dabei in einer gewissen Reihenfolge hintereinander angeordnet. Jede Eingangsschaltung 1a, 1b und 1c enthält die Kaskadenschaltung eines Eingangswandlers 2a, 2b bzw. 2c und eines nachgeschalteten Multiplizierers 3a, 3b bzw. 3c. In jeder Eingangsschaltung 1a, 1b und 1c ist ausserdem jedem Multiplizierer 3a, 3b bzw. 3c ein Spannungs/Frequenz-Wandler 4a, 4b bzw. 4c in Kaskade nachgeschaltet.

Die Eingangswandler 2a, 2b und 2c sind z. B. an sich bekannte Spannungs/Strom-Wandler, deren Eingangssignal eine der drei Phasenspannungen u1, u2 oder u3 ist. Die Spannungs/Strom-Wandler 2a, 2b und 2c wandeln ihr Eingangssignal um in einen proportionalen Strom, der den nachfolgenden Multiplizierer 3a, 3b bzw. 3c speist. Diese Multiplizierer 3a, 3b und 3c sind vorzugsweise Hallelemente. Die zu den Phasenspannungen u1, u2 und u3 gehörenden Ströme erzeugen die proportionalen Magnetinduktionen B1, B2 und B3, die das zugehörige Hallelement durchfliessen. Am Ausgang eines jeden Multiplizierers 3a, 3b und 3c ist somit eine Hallspannung vorhanden, die proportional dem Produkt uk.Bk und damit proportional der zugehörigen Leistung Pk ist, wobei k = 1, 2 oder 3 gilt. Die Spannungs/Frequenz-Wandler 4a, 4b und 4c wandeln die Ausgangsspannung der Multiplizierer 3a, 3b und 3c und damit die zugehörige Leistung Pk jeweils um in eine porportionale Frequenz.

Jedem Spannungs/Frequenz-Wandler 4a, 4b bzw. 4c ist in der Eingangsschaltung 1a, 1b bzw. 1c ein Addierer 5a, 5b bzw. 5c in Kaskade nachgeschaltet mit Hilfe eines ersten Eingangs E11 oder E12 des jeweiligen Addierers 5a, 5b bzw. 5c. Der Ausgang des Addierers 5a, 5b und 5c bildet seinerseits jeweils den Ausgang der zugehörigen Eingangsschaltung 1a, 1b oder 1c. Der zweite Eingang E21 oder E22 des Addierers 5a, 5b und 5c ist jeweils mit dem Ausgang der vorhergehenden Eingangsschaltung 1a bzw. 1b der Reihenfolge direkt oder über weitere Bauelemente verbunden.

In der ersten Eingangsschaltung 1a der Reihenfolge ist der zugehörige Addierer 5a jedoch nur fakultativ vorhanden und daher gestrichelt dargestellt. Ein Addierer ist somit mindestens imm er ab der zweiten Eingangsschaltung 1b der Reihenfolge jedem Spannungs/Frequenz-Wandler 4b bzw. 4c in Kaskade nachgeschaltet. Falls, wie nachfolgend angenommen, in der ersten Eingangsschaltung 1a der Reihenfolge ein Addierer 5a vorhanden ist, ist dessen zweiter Eingang bzw. sind alle dessen zweiten Eingänge an Masse zu legen (siehe Fig. 1).

Da die Leistungen Pk sowohl positiv als auch negativ sein können, ist jeder Spannungs/Frequenz-Wandler 4a, 4b und 4c in der Regel mit zwei Ausgängen versehen, einen für die positive und einen für die negative Leistung Pk. Derartige Spannungs/Frequenz-Wandler werden oft in Einphasenzählern verwendet und sind somit an sich bekannt. Sie sind nicht Gegenstand der Erfindung und werden daher nicht näher beschrieben. Zum besseren Verständnis sei nur erwähnt, dass die Spannungs/Frequenz-Wandler 4a, 4b und 4c je eine Weiche enthalten, die die Ausgangsimpulse des Spannungs/Frequenz-Wandlers 4a, 4b und 4c dem einen Ausgang zuführt, wenn die Leistung Pk positiv ist, und sie dem anderen Ausgang zuleitet, wenn die Leistung Pk negativ ist.

Im Fall, dass die Spannungs/Frequenz-Wandler 4a, 4b und 4c zwei Ausgänge besitzen (siehe Fig. 1), besitzen die Addierer 5a, 5b und 5c je zwei erste Eingänge E11 und E12 sowie zwei zweite Eingänge E21 und E22. Zur positiven Leistung Pk gehört z. B. das Eingangspaar E11 und E21 und zur negativen Leistung das Eingangspaar E12 und E22.

Jeder der beiden Ausgänge der Spannungs/Frequenz-Wandler 4a, 4b und 4c ist jeweils mit einem der ersten Eingänge E11 bzw. E12 seines zugehörigen Addierers 5a, 5b bzw. 5c verbunden. Jeder Addierer 5a, 5b und 5c und damit auch jede Eingangsschaltung 1a, 1b und 1c besitzt ebenfalls zwei Ausgänge, einen für die Impulse der positiven und einen für die Impulse der negativen Leistung Pk. Die zweiten Eingänge E21 und E22 eines jeden Addierers 5a, 5b und 5c sind dann jeweils mit demjenigen Ausgang der vorhergehenden Eingangsschaltung 1a bzw. 1b der Reihenfolge verbunden, der einer gleichartigen positiven oder negativen Leistung entspricht.

Wegen der Miniaturisierung der Eingangsschaltungen 1a, 1b und 1c ist es oft schwierig, sie mit zwei Ausgangsanschlüssen zu versehen. In diesem Fall sind vorzugsweise die beiden Ausgänge der Eingangsschaltungen 1a und 1b jeweils über eine Kaskadenschaltung eines Ternärcodierers 6a bzw. 6b und eines nachgeschalteten Ternärdecodierers 7a bzw. 7b mit den zweiten Eingängen E21 und E22 der Addierer 5b und 5c verbunden. Der Ternärcodierer wandelt die zugehörigen Impulse der positiven Leistung um in positive Impulse und diejenigen der negativen Leistung um in negative Impulse, so dass am Ausgang eines jeden Ternärcodierers 6a und 6b zwar drei Impulspegel -VSS, 0 Volt und +VDD vorhanden sind, dieser Ausgang jedoch nur einpolig ist, was raumsparende Anschlüsse ergibt. Die Verbindung zum Ternärdecodierer 7a bzw. 7b erfolgt dann über einen einzelnen Draht. Der Ternärdecodierer 7a bzw. 7b, der räumlich in der Nähe der nachfolgenden Eingangsschaltung der Reihenfolge angeordnet ist und z. B. mit dieser Eingangsschaltung integriert werden kann, wandelt dann die Ternärimpulse zurück in normale Binärimpulse, die je nach vorhandener positiver oder negativer Leistung an einem der beiden Ausgänge des Ternärdecodierers 7a bzw. 7b erscheinen. Diese beiden Ausgänge sind dann mit den zweiten Eingängen E21 und E22 des nachfolgenden Addierers 5b bzw. 5c verbunden.

Auch die beiden Ausgänge des Addierers 5c der in der Reihenfolge letzten Eingangsschaltung 1c können fakultativ noch mit den Eingängen eines weiteren Ternärcodierers 6c verbunden sein, z. B. zum Zweck einer Fernübertragung. In diesem Fall bildet der Ausgang des Ternärcodierers 6c einen zeitseriellen Ausgang der Anordnung, an dem ternärcodierte Impulse anstehen.

Die beiden Ausgänge des Addierers 5c der letzten Eingangsschaltung 1c der Reihenfolge sind mit dem Vorwärtszähl-Eingang und dem Rückwärtszähl-Eingang eines Vorwärts/Rückwärts-Zählers 8 verbunden, der zwei Ausgänge besitzt. Der Vorwärts/Rückwärts-Zähler 8 ist gleichzeitig auch Frequenzteiler. Die Frequenz der Binärimpulse, die an dem einen seiner Ausgänge erscheint, entspricht einem positiven Wert der Leistungssumme, und diejenige, die an dem anderen Ausgang erscheint, einem negativen Wert der Leistungssumme. Der erste Ausgang des Vorwärts/Rückwärts-Zählers 8 ist über einen ersten Motortreiber 9a mit einem ersten Speisepol eines ersten Schrittmotors 10a und/oder über einen ersten Diodentreiber 11a mit der Anode einer Leuchtdiode 12a verbunden. Der zweite Ausgang des Vorwärts/Rückwärts-Zählers 8 ist dagegen über einen zweiten Motortreiber 9b mit einem ersten Speisepol eines zweiten Schrittmotors 10b und/oder über einen zweiten Diodentreiber 11b mit der Anode einer zweiten Leuchtdiode 12b verbunden. Der zweite Speisepol der Schrittmotoren 10a und 10b sowie die Kathode der Leuchtdioden 12a und 12b liegen jeweils an Masse. Die beiden Schrittmotoren 10a und 10b betätigen je eine mechanische Anzeige 13a bzw. 13b.

Anstelle der Bauelementegruppen 9a; 10a; 13a und 9b; 10b; 13b können auch rein elektronische Bauelementegruppen verwendet werden, die z. B. je eine Segment-Anzeige aus Leuchtdioden oder Flüssigkristallen enthalten. Der Vorwärts/Rückwärts-Zähler 8 ist dann vorzugsweise auch mit nichtflüchtigen Speichern aufgebaut, damit sein Informationsinhalt bei Spannungsausfall nicht verloren geht.

Ein Block K bestehend aus der Bauelementegruppe 8; 9a; 9b; 11a; 11b sowie die Blöcke 6a, 6b, 6c, 7a und 7b können z. B. als integrierte Schaltung aufgebaut und Bestandteil einer jeden Eingangsschaltung 1a, 1b und 1c sein. Dies ist vorallem dann von wirtschaftlichem Interesse, wenn die Eingangsschaltung 1a, 1b und 1c als integrierte Schaltung aufgebaut werden soll. In diesem Fall arbeiten die Blöcke K der Eingangsschaltung 1a und 1b im Leerlauf und ihre Ausgänge sind nirgendswo angeschlossen. Nur die Ausgänge des Blocks K der letzten Eingangsschaltung 1c sind dann mit Schrittmotoren 10a und 10b sowie mit Leuchtdioden 12a und 12b belastet.

Die Verdrahtung der Addierer 5a, 5b und 5c entspricht elektrisch einer Kaskadenschaltung dieser Addierer. Durch diese Kaskadenschaltung werden einerseits diejenigen Ausgangsimpulse der Spannungs/Frequenz-Wandler 4a, 4b und 4c zeitlich in Reihe geschaltet, die einer positiven Leistung Pk entsprechen, d. h. ihre Frequenzen addieren sich, so dass an einem der beiden Ausgänge des letzten Addierers 5c der Reihenfolge Binärimpulse erscheinen, deren Frequenz proportional der Summe aller positiven Leistungen Pk ist. Anderseits werden durch diese Kaskadenschaltung auch diejenigen Ausgangsimpulse der Spannungs/Frequenz-Wandler 4a, 4b und 4c zeitlich in Reihe geschaltet, die einer negativen Leistung Pk entsprechen, d. h. auch ihre Frequenzen addieren sich, so dass an dem anderen der beiden Ausgänge des letzten Addierers 5c der Reihenfolge Binärimpulse erscheinen, deren Frequenz proportional der Summe aller negativen Leistungen Pk ist.

Der Vorwärts/Rückwärts-Zähler 8 zählt die Ausgangsimpulse des Addierers 5c, die einer positiven Leistung entsprechen, vorwärts und diejenigen, die einer negativen Leistung entsprechen, rückwärts. Sein Zählwert entspricht dann der algebraischen Summe beider Leistungsarten. Ist diese algebraische Summe positiv, dann werden seine Ausgangsimpulse, z. B. vom Schrittmotor 10a, gezählt und mittels der Anzeige 13a angezeigt. Ist die algebraische Summe dagegen negativ, dann werden seine Ausgangsimpulse vom Schrittmotor 10b gezählt und mittels der Anzeige 13b angezeigt.

Die Motortreiber 9a und 9b sowie die Diodentreiber 11a und 11b sind an sich bekannte Schaltungen und dienen nur dazu, ihre Eingangsimpulse sowohl spannungsmässig als auch strommässig den Bedürfnissen der Schrittmotoren 10a und 10b bzw. der Leuchtdioden 12a und 12b anzupassen.

Die Leuchtdioden 12a und 12b, die im Rhythmus der Ausgangsfrequenzen (eine für die positive und eine für die negative Summe der Leistungen) des Vorwärts/Rückwärts-Zählers 8 blinken, stellen je einen zeitseriellen Ausgang der Anordnung dar, der es gestattet, mittels einer externen, nicht dargestellten optischen Einrichtung diese Ausgangsfrequenzen und damit auch die positive und negative Summe der Leistungen zu messen.

Es ist klar, dass wenn nur eine Art positive oder negative Energie vorhanden ist und gemessen werden muss, eine der beiden Baugruppen 9a; 10a; 11a; 12a; 13a bzw. 9b; 10b; 11b; 12b; 13b überflüssig ist und weggelassen werden kann.

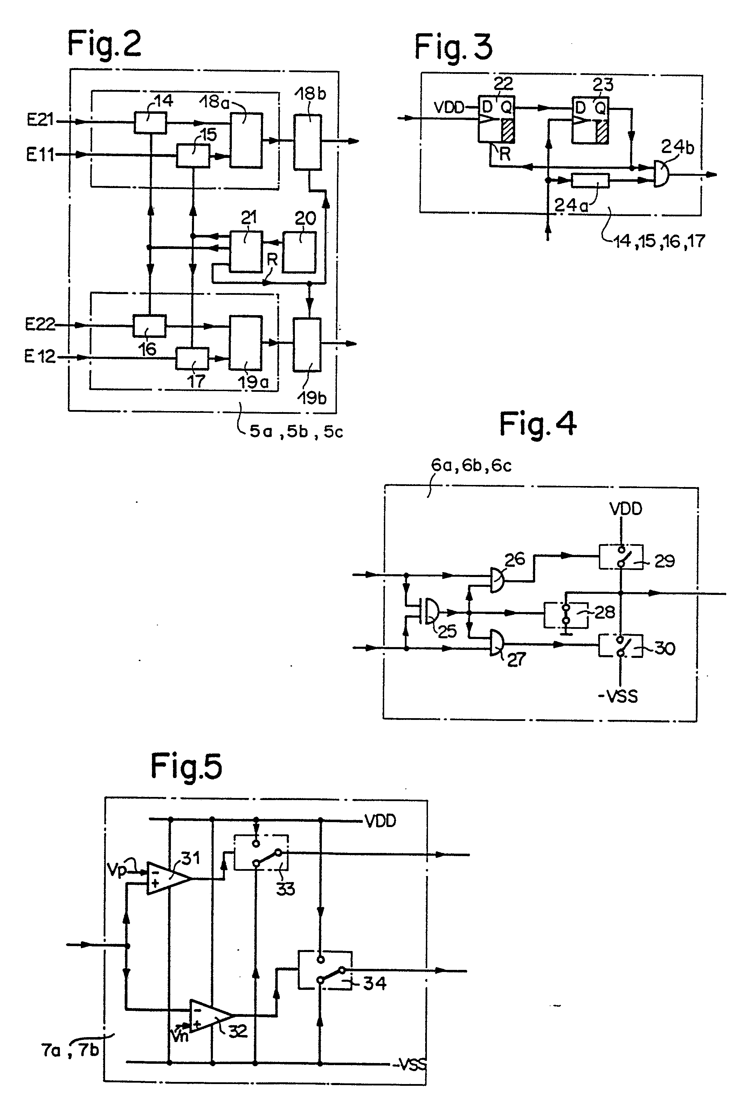

Alle Addierer 5a, 5b und 5c besitzen einen gleichen, z. B. wie in der Fig. 2 dargestellten Aufbau. Jeder Addierer 5a, 5b und 5c besteht dann aus vier Synchronisierungsanordnungen 14, 15, 16 und 17, einem ersten Gatter 18a, einem zweiten Gatter 19a, einem Taktgenerator 20, einem Verzögerungsglied 21, einem ersten Impulsformer 18b und einem zweiten Impulsformer 19b.

In jedem Addierer 5a, 5b und 5c ist dessen Eingängen E11, E12, E21 und E22 je eine Synchronisierungsanordnung 14, 15, 16 bzw. 17 zugeordnet, d. h. jeder dieser Eingänge E11, E12, E21 und E22 ist innerhalb des Addierers mit einem Dateneingang einer Synchronisierungsanordnung 14, 15, 16 bzw. 17 verbunden. Die Synchronisierungsanordnungen 14 bis 17 dienen jeweils zur zeitverschobenen Synchronisierung zweier zueinander gehöriger Eingangssignale des jeweiligen Addierers 5a, 5b und 5c. In jedem Addierer 5a, 5b und 5c sind die Ausgänge der beiden zueinander gehörigen Synchronisierungsanordnungen 14 und 15 mit je einem Eingang des ersten Gatters 18a und diejenigen der beiden zueinander gehörigen Synchronisierungsanordnungen 16 und 17 mit je einem Eingang des zweiten Gatters 19a verbunden. Die beiden Gatter 18a und 19a sind vorzugsweise Oder-Gatter und dienen der zeitseriellen Addition der Ausgangsimpulse der beiden zugehörigen Synchronisierungsanordnungen 14 und 15 bzw. 16 und 17. Der Ausgang des Taktgenerators 20 ist auf einen Eingang des Verzögerungsgliedes 21 geführt, welches drei Ausgänge besitzt. Sein erster Ausgang ist mit je einem Takteingang der Synchronisierungsanordnungen 14 und 16, sein zweiter Ausgang mit je einem Takteingang der Synchronisierungsanordnungen 15 und 17 und sein dritter Ausgang mit je einem Steuereingang der Impulsformer 18b und 19b verbunden. Das Gatter 18a und der Impulsformer 18b sowie das Gatter 19a und der Impulsformer 19b sind jeweils in der angegebenen Reihenfolge in Kaskade geschaltet. Die Ausgänge der Impulsformer 18b und 19b bilden jeweils die Ausgänge der Addierer 5a, 5b und 5c.

Alle Synchronisierungsanordnungen 14 bis 17 sind gleich aufgebaut und besitzen z. B. den in der Fig. 3 dargestellten Aufbau. Sie bestehen dann aus einem ersten D-Flip Flop 22, einem zweiten D-Flip Flop 23, einem Verzögerungsglied 24a und einem Und-Gatter 24b. Der Eingang der Synchronisierungsanordnung 14, 15, 16 und 17 ist innerhalb derselben mit dem Takteingang des ersten D-Flip Flops 22 verbunden, während ihr Ausgang durch den Ausgang des Und-Gatters 24b gebildet ist. Der D-Eingang des ersten D-Flip Flops 22 liegt an einer Speisespannung VDD, die den Logikwert "1" darstellt, während sein Q-Ausgang mit dem D-Eingang des zweiten Flip Flops 23 verbunden ist, dessen Q-Ausgang seinerseits mit dem Rückstelleingang R des ersten D-Flip Flops 22 und mit einem ersten Eingang des Und-Gatters 24b verbunden ist. Der Takteingang der Synchronisierungsanordnungen 14 bis 17 ist innerhalb derselben auf den Takteingang des zweiten D-Flip Flops 23 und über das Verzögerungsglied 24a auf einen zweiten Eingang des Und-Gatters 24b geführt. Durch eine Schaltverzögerung zwischen dem Takteingang und dem Q-Ausgang des Flip Flops 23 entsteht nach dem Wechseln des Signals am D-Eingang des Flip Flops 23 vom Logikwert "1" zum Logikwert "0" beim nächsten Taktimpuls ein Störimpuls am Ausgang des Und-Gatters 24b, dessen zeitliche Länge genau der Schaltverzögerung entspricht. Das Verzögerungsglied 24a dient dazu, diesen Störimpuls zu unterdrücken.

Die rechteckförmigen Ausgangsimpulse des Taktgenerators 20 erreichen einerseits idealerweise einen ersten Ausgang des Verzögerungsgliedes 21 ohne Zeitverzögerung und erreichen anderseits einen zweiten Ausgang des Verzögerungsgliedes 21 mit einer gewissen Zeitverzögerung. Diese Zeitverzögerung entspricht vorzugsweise einer halben Impulsperiode. Die Synchronisierungsanordnungen 14 und 15 bzw. 16 und 17 werden dann im Gegentakt so synchronisiert, dass ihre Ausgangsimpulse sich nicht überlappen. In diesem Fall können die Gatter 18a und 19a reine Oder-Gatter sein. Sie dienen der zeitseriellen Addition der Ausgangsimpulse der Synchronisierungsanordnungen 14 und 15 bzw. 16 und 17. Die eigentliche Synchronisierung (siehe Fig. 3) erfolgt innerhalb der Synchronisierungsanordnungen 14 bis 17 mit Hilfe des zweiten D-Flip Flops 23, der das Ausgangssignal des ersten D-Flip Flops 22 mit der positivgehenden Flanke der am Takteingang der Synchronisierungsanordnungen 14 bis 17 anstehenden Taktimpulse synchronisiert indem er das erwähnte Ausgangssignal erst zum Zeitpunkt der positivgehenden Flanke an seinem Q-Ausgang weitergibt. Das Und-Gatter 24b begrenzt die zeitliche Länge der Ausgangsimpulse des zweiten D-Flip Flops 23 auf diejenige der Taktimpulse. Das erste D-Flip Flop 22 ist nur eine Hilfsschaltung, die dazu dient, die zeitliche Länge der Eingangsimpulse des zweiten D-Flip Flops 23 zu begrenzen.

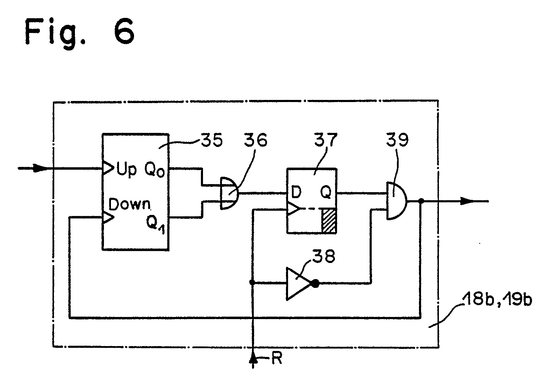

Die Impulsformer 18b und 19b dienen dazu, ihre kurzen Eingangsimpulse so zu verlängern, dass diese durch die Synchronisierschaltung der nachfolgenden Eingangsschaltung 1b bzw. 1c wiederum synchronisiert werden können. Durch die Addition zweier Eingangsimpulse ist es nämlich möglich, dass in kurzem Abstand drei Impulse auf den Eingang eines Impulsformers 18b bzw. 19b abgegeben werden. Diese Impulse müssen nun wieder mit verlängerter Impulsbreite durch den betreffenden Impulsformer 18b bzw. 19b weitergegeben werden, d. h. ein Impulsspeicher für bis zu drei Impulse muss in jedem Impulsformer 18b und 19b vorhanden sein. Die mittlere Ein- und Ausgangsfrequenz der Impulsformer 18b und 19b bleibt dabei genau gleich, d. h. die Impulszahl wird durch die Impulsformung nicht verändert. Die Impulsbreite der Ausgangsimpulse der Impulsformer 18b und 19b ist gegeben durch ein Steuersignal R, welches vom dritten Ausgang des Verzögerungsgliedes 21 den Steuereingängen der Impulsformer 18b und 19b zugeführt wird. Die beiden Impulsformer 18b und 19b sind gleich aufgebaut und besitzen z. B. den in der Fig. 6 dargestellten Aufbau.

Der in der Fig. 4 dargestellte Ternärcodierer 6a, 6b bzw. 6c besteht aus einem Exklusiv-Oder-Gatter 25, einem ersten Und-Gatter 26, einem zweiten Und-Gatter 27, einem ersten Schalter 28, einem zweiten Schalter 29 und einem dritten Schalter 30. Innerhalb des Ternärcodierers 6a, 6b bzw. 6c ist dessen erster Eingang mit je einem ersten Eingang des Exklusiv-Oder-Gatters 25 und des ersten Und-Gatters 26 verbunden, während sein zweiter Eingang auf den zweiten Eingang des Exklusiv-Oder-Gatters 25 und auf einen ersten Eingang des zweiten Und-Gatters 27 geführt ist. Der Ausgang des Exklusiv-Oder-Gatters 25 ist mit je einem zweiten Eingang der Und-Gatter 26 und 27 sowie mit einem Steuereingang des ersten Schalters 28 verbunden, der einen Oeffnungskontakt besitzt. Der Ausgang der Und-Gatter 26 und 27 ist mit einem Steuereingang des Schalters 29 bzw. 30 verbunden. Die Schalter 29 und 30 besitzen je einen Schliesskontakt. Der Ausgang des Ternärcodierers 6a, 6b bzw. 6c ist jeweils über den ersten Schalter 28 mit Masse, über den zweiten Schalter 29 mit einer positiven Speisespannung VDD und über den dritten Schalter 30 mit einer negativen Speisespannung -VSS verbunden.

Beim Vorhandensein eines Impulses an einem der beiden Eingänge des Ternärcodierers 6a, 6b bzw. 6c wird das zugehörige Und-Gatter 26 bzw. 27 freigegeben durch das Exklusiv-Oder-Gatter 25, dessen Ausgangssignal dann einen Logikwert "1" besitzt. Dadurch wird gleichzeitig der Schalter 28 geöffnet. Am Ausgang des Und-Gatters 26 oder 27 erscheint ein Logikwert "1", der den zugehörigen Schalter 29 bzw. 30 betätigt, so dass entweder die positive Speisespannung VDD über den Schalter 29 oder die negative Speisespannung -VSS über den Schalter 30 am Ausgang des Ternärcodierers 6a, 6b bzw. 6c erscheint. Ist an keinem seiner beiden Eingänge ein Impuls vorhanden, also in den Impulslücken, dann besitzt der Ausgang des Exklusiv-Oder-Gatters 25 einen Logikwert "0", die beiden Und-Gatter 26 und 27 sind gesperrt und der Schalter 28 ist geschlossen, so dass 0 Volt am Ausgang des Ternärcodierers 6a, 6b bzw. 6c liegt.

Der in der Fig. 5 dargestellte Ternärdecodierer 7a bzw. 7b besteht aus einem ersten Komparator 31, einem zweiten Komparator 32, einem ersten Umschalter 33 und einem zweiten Umschalter 34. Der einzige Eingang des Ternärdecodierers 7a bzw. 7b ist auf den nichtinvertierenden Eingang des ersten Komparators 31 und auf den invertierenden Eingang des zweiten Komparators 32 geführt, deren Ausgang jeweils mit einem Steuereingang des Umschalters 33 bzw. 34 verbunden ist. Der invertierende Eingang des ersten Komparators 31 liegt an einer ersten Referenzspannung Vp und der nichtinvertierende Eingang des zweiten Komparators an einer zweiten Referenzspannung Vn. Ein erster Ausgang des Ternärdecodierers 7a bzw. 7b wird mittels des ersten Umschalters 33 und sein zweiter Ausgang mittels des zweiten Umschalters 34 entweder an eine positive Speisespannung VDD oder an eine negative Speisespannung -VSS gelegt. Die beiden Komparatoren 31 und 32 sind durch die Speisespannungen VDD und -VSS gespeist.

Es gelten:
VDD>Vp>0 Volt
-VSS<Vn<0 Volt

Erscheint am Eingang des Ternärdecodierers 7a bzw. 7b ein positiver Impuls, dessen Amplitude grösser als Vp ist, dann erscheint am Ausgang des ersten Komparators 31 ein Logikwert "1", der den ersten Umschalter 33 betätigt, so dass am zugehörigen Ausgang des Ternärdecodierers 7a bzw. 7b, an dem normalerweise die Speisespannung -VSS ansteht, kurzzeitig für die Dauer des Impulses die Speisespannung VDD erscheint. Erscheint dagegen am Eingang des Ternärdecodierers 7a bzw. 7b ein negativer Impuls, dessen Amplitude grösser als der Absolutwert von Vn ist, dann erscheint am Ausgang des zweiten Komparators 32 ein Logikwert "1", der den zweiten Umschalter 34 betätigt, so dass diesmal am anderen Ausgang des Ternärdecodierers 7a bzw. 7b, an dem auch normalerweise die Speisespannung -VSS ansteht, kurzzeitig für die Dauer des Impulses die Speisespannung VDD erscheint. VDD bedeutet hier Logikwert "1" und -VSS bedeutet Logikwert "0".

Die in der Fig. 6 dargestellten Impulsformer 18b und 19b bestehen aus einem Vorwärts/Rückwärts-Zähler 35, einem Oder-Gatter 36, einem D-Flip Flop 37, einem Inverter 38 und einem Und-Gatter 39. Der Eingang der Impulsformer 18b und 19b ist innerhalb derselben mit einem vorwärtszählenden Takteingang "Up" des Vorwärts/Rückwärts-Zählers 35 verbunden, während dessen rückwärtszählender Takteingang "Down" vom Ausgang des Und-Gatters 39 angesteuert ist. Die beiden Ausgänge $Q_0$ und $Q_1$ des Vorwärts/Rückwärts-Zählers 35 sind je mit einem Eingang des Oder-Gatters 36 verbunden, dessen Ausgang seinerseits auf den D-Eingang des D-Flip Flops 37 geführt ist. Der Steuereingang der Impulsformer 18b und 19b, an dem das Steuersignal R ansteht, ist direkt mit dem Takteingang des D-Flip Flops 37 und über den Inverter 38 mit einem ersten Eingang des Und-Gatters 39 verbunden. Der Q-Ausgang des D-Flip Flops 37 ist auf den zweiten Ausgang des Und-Gatters 39 geführt, dessen Ausgang den Ausgang der Impulsformer 18b und 19b bildet.

Mit der positiven Flanke eines jeden Eingangsimpulses der Impulsformer 18b und 19b wird der Inhalt des Vorwärts/Rückwärts-Zählers 35 um den Wert Eins erhöht. Mit der positiven Flanke eines jeden Ausgangsimpulses der Impulsformer 18b und 19b wird der Inhalt des Vorwärts/Rückwärts-Zählers 35 um den Wert Eins herabgesetzt. Sobald der binäre Zählerstand Null ist, erscheint am Ausgang des Oder-Gatters 36 ein Logikwert "0", d. h. mit dem nächsten Taktimpuls des Steuersignals R erscheint ein Logikwert "0" am Ausgang Q des D-Flip Flops 37. Dadurch wird das Und-Gatter 39 gesperrt und es wird kein Impuls mehr durch den Impulsformer 18b bzw. 19b abgegeben. Da die beiden Impulsformer 18b und 19b das gleiche Steuersignal R besitzen, kann gleichzeitig an ihrem Ausgang je ein Impuls erscheinen. Durch das Exklusiv-Oder-Gatter 25 im nachgeschalteten Ternärcodierer 6a, 6b bzw. 6c (siehe Fig. 4) werden gleichzeitig erscheinende Impulse unterdrückt und nicht weitergegeben, was kein Nachteil ist, da die Summe einer positiven und einer negativen gleichwertigen Leistung immer Null ist.

## Ansprüche

1. Anordnung zur Ermittlung einer Leistungssumme und zur Verwendung insbesondere in Mehrphasen-Elektrizitätszählern mit mindestens zwei Eingangsschaltungen (1a, 1b, 1c), die je eine Kaskadenschaltung eines Eingangswandlers (2a, 2b, 2c) und eines nachgeschalteten Multiplizierers (3a, 3b, 3c) enthalten, mit mindestens einem Spannungs/Frequenz-Wandler (4a, 4b, 4c) und mit mindestens einem Addierer (5a, 5b, 5c), dadurch gekennzeichnet, dass jedem Multiplizierer (3a, 3b, 3c) ein Spannungs/Frequenz-Wandler (4a, 4b, 4c) in Kaskade nachgeschaltet ist, dass die Eingangsschaltungen (1a, 1b, 1c) in einer Reihenfolge hintereinander angeordnet sind, dass mindestens ab der zweiten Eingangsschaltung (1b) jedem Spannungs/Frequenz-Wandler (4a, 4b, 4c) ein Addierer (5a, 5b, 5c) in Kaskade nachgeschaltet ist mit Hilfe eines ersten Eingangs (E11, E12) des Addierers (5a, 5b, 5c), dessen Ausgang seinerseits auf den Ausgang der Eingangsschaltung (1a, 1b, 1c) geführt ist und dessen zweiter Eingang (E21, E22) jeweils mit dem Ausgang der vorhergehenden Eingangsschaltung (1a bzw. 1b) verbunden ist.

2. Anordnung nach Anspruch 1, dadurch gekennzeichnet, dass jeder Spannungs/Frequenz-Wandler (4a, 4b, 4c) zwei Ausgänge besitzt, einen für die positive und einen für die negative Leistung, und dass jeder Ausgang mit einem ersten Einang (E11, E12) eines Addierers (5a, 5b, 5c) verbunden ist, der ebenfalls zwei Ausgänge besitzt, einen für die positive und einen für die negative Leistung, wobei die beiden Ausgänge der Addierer (5a, 5b, 5c) gleichzeitig zwei Ausgänge der zugehörigen Eingangsschaltung (1a, 1b, 1c) bilden, und dass der zweite Eingang (E21, E22) des Addierers (5a, 5b, 5c) jeweils mit demjenigen Ausgang der vorhergehenden Eingangsschaltung (1a bzw. 1b) verbunden ist, der einer gleichartigen positiven oder negativen Leistung entspricht.

3. Anordnung nach Anspruch 2, dadurch gekennzeichnet, dass beide Ausgänge eines Addierers (5a, 5b) jeweils über eine Kaskadenschaltung eines Ternärcodierers (6a, 6b) und eines nachgeschalteten Ternärdecodierers (7a, 7b) mit den zweiten Eingängen (E21, E22) der Addierer (5b, 5c) der nachfolgenden Eingangsschaltung (1b, 1c) verbunden sind.

4. Anordnung nach einem der Ansprüche 1 bis 3, dadurch gekennzeichnet, dass in jedem Addierer (5a, 5b, 5c) dessen Eingängen (E11, E12, E21, E22) je eine Synchronisierungsanordnung (14, 15, 16, 17) zugeordnet ist zur zeitverschobenen Synchronisierung zweier zueinander gehöriger Eingangssignale des Addierers (5a, 5b, 5c) und dass in jedem Addierer (5a, 5b, 5c) die Ausgänge zweier zueinander gehöriger Synchronisierungsanordnungen (14 und 15 bzw. 16 und 17) mit je einem Eingang eines Gatters (18a bzw. 19a) verbunden sind zur zeitseriellen Addition der Ausgangsimpulse der beiden Synchronisierungsanordnungen (14 und 15 bzw. 16 und 17), wobei der Ausgang der Gatter (18a, 19a) je auf einen Ausgang des Addierers (5a, 5b, 5c) geführt ist.

Fig.1

EP 0 302 170 A1

## Fig.2

E21 → [14] → [18a] → [18b] →
E11 → [15] →

[21] [20]
R

E22 → [16] →
E12 → [17] → [19a] → [19b] →

5a, 5b, 5c

## Fig.3

VDD → [D Q 22] → [D Q 23] → [24b] →
R
[24a]

14, 15, 16, 17

## Fig.4

6a, 6b, 6c

VDD
→ [26] → [29]
[25] → [28] →
→ [27] → [30]
-VSS

## Fig.5

VDD
Vp → [31] → [33] →
→
[34] →
Vn → [32]
7a, 7b
-VSS

# Fig. 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-2 951 627 (ZÄHLER)<br>* Seiten 4-7 *<br>--- | 1 | G 01 R 21/00 |
| A | EP-A-0 052 255 (SIEMENS)<br>--- | | |
| A | CH-A- 333 225 (SIEMENS)<br>----- | | |

**RECHERCHIERTE SACHGEBIETE (Int. Cl.4)**

G 01 R

Der vorliegende Recherchenbericht wurde für alle Patentansprüche erstellt

| Recherchenort | Abschlußdatum der Recherche | Prüfer |
|---|---|---|
| DEN HAAG | 14-09-1988 | HOORNAERT W. |